(19) Europäisches Patentamt / European Patent Office / Office européen des brevets

(11) **EP 2 434 363 B1**

(12) **EUROPEAN PATENT SPECIFICATION**

(45) Date of publication and mention of the grant of the patent:
**15.05.2013  Bulletin 2013/20**

(51) Int Cl.:
***G05F 1/56*** *(2006.01)*   ***G01R 31/00*** *(2006.01)*

(21) Application number: **10306040.6**

(22) Date of filing: **27.09.2010**

(54) **Presence and operability test of a decoupling capacitor**

Präsenz- und Bedienbarkeitsprüfung eines Entstörkondensators

Test de présence et d'opérabilité d'un condensateur de découplage

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(43) Date of publication of application:
**28.03.2012  Bulletin 2012/13**

(73) Proprietor: **ST-Ericsson SA**
**1228 Plan-les-Ouates (CH)**

(72) Inventor: **Belet, Christophe**
**72250, PARIGNE L'EVEQUE (FR)**

(74) Representative: **Cabinet Plasseraud**
**52, rue de la Victoire**
**75440 Paris Cedex 09 (FR)**

(56) References cited:
**US-A- 5 880 589**   **US-A1- 2009 039 848**
**US-A1- 2009 072 984**   **US-B1- 6 424 058**

## Description

## BACKGROUND

## Technical Field

The invention generally relates to the test of the presence and the operability of decoupling capacitors, in order to detect malfunctioning and/or disconnected decoupling capacitors in an electronic device.

## Related Art

Electronic device manufacturers perform production tests to ensure that any device works properly. However, in electronic device production, it is not possible to test a device at 100%. As a consequence, passive components like decoupling capacitors are generally considered implicitly tested if the electronic device works when it is tested in mass production.

Also, electronic devices usually comprise voltage regulators for supplying loads such as electronic circuits. Each voltage regulator needs one or several decoupling capacitors for reducing noise caused by power consumption swing of circuit supplied by voltage regulator or caused by coupling with other parts of the device. Indeed, a decoupling capacitor, when it is suitably connected and works properly, is able to decouple signal from another signal.

If decoupling capacitors are not present, for example if capacitors are missing or are not well connected during component assembly or are defective, electronic device should still be able to work in normal condition (for example at room temperature) but could crash or be inoperative in extreme condition.

Some prior art solutions to detect the presence of decoupling capacitors involve visual inspection or test signal analyzing. These solutions have some drawbacks such as high miss-rate, and need for special in-built hardware and intrusive behavior. Moreover, they may not be able to detect the operability of a decoupling capacitor, that is to say detect if a decoupling capacitor, which is present, is not well connected and/or does not work properly.

A known method for checking electrical connection of decoupling capacitor is based on the measure of the discharge duration of the decoupling capacitor.

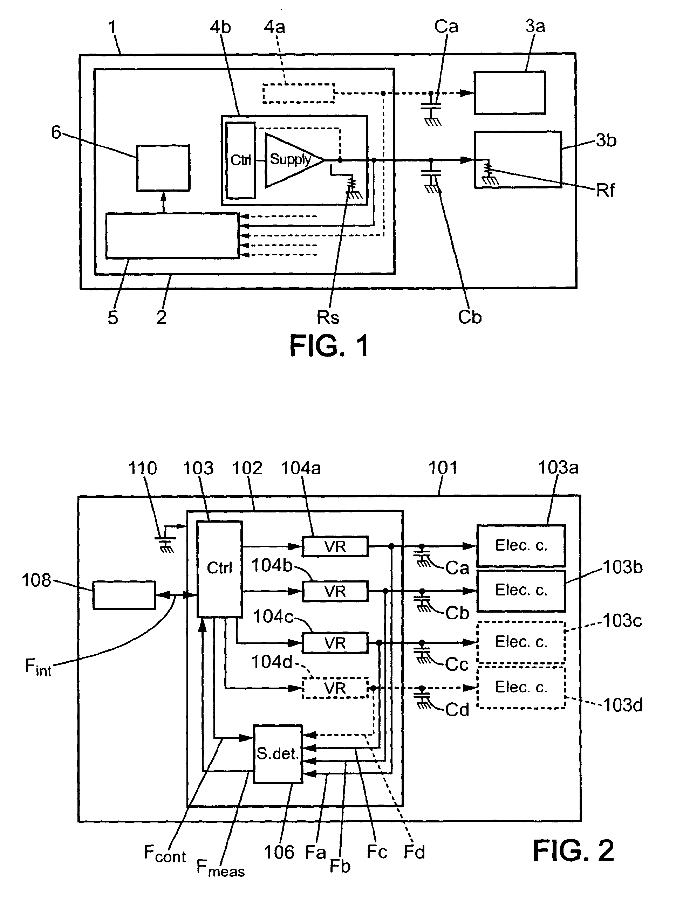

Fig.1 represents an electronic device 1 comprising a power management unit 2 and two electronic circuit blocks 3a, 3b. The power management unit 2 comprises two voltage regulator blocks 4a, 4b, a control block 5 and a GPADC (General Purpose Analog To Digital Converter) block 6. The electronic device 1 also comprises two decoupling capacitors Ca, Cb, respectively placed between the voltage regulator blocks 4a, 4b and the corresponding electronic circuit blocks 3a, 3b.

Each voltage regulator block 4a, 4b comprises a programmable discharge load Rs (only represented in voltage regulator 4b in Fig.1). Each voltage regulator block 4a, 4b is able to be switched ON/OFF and to connect its programmable discharge load Rs.

The method for checking electrical connection of decoupling capacitor is based on a RC (Resistor * Capacitor) discharge circuitry. For example, for voltage regulator 4b, the RC discharge circuitry comprises capacitor C, which is the decoupling capacitor Cb, and load impedance R, which is the sum of the programmable discharge load Rs and the equivalent impedance Rf of the electronic circuit block 3b. Voltage discharge waveform is then:

$$V/V0 = \exp(-t/\tau) \text{ with } \tau = R \times C$$

To identify if decoupling capacitor Cb is present, voltage measurement is performed some time (delay) after the voltage regulator block 4b has been switched off. For example, voltage measurement is performed at time $t = \tau$ after the voltage regulator block 4b has been switched off. If voltage measurement is in a predetermined range, decoupling capacitor Cb is considered to be present and well connected.

A drawback of this method is that it requires switching off the voltage regulator block for measuring the discharge duration. However, in some electronic devices, voltage regulator blocks can't be switched off without switching off the device itself. As a consequence, this method is only applicable for electronic devices which comprise voltage regulator blocks able to be switched off, which limit the testing coverage. Moreover, this method requires an accurate delay synchronization to perform voltage measurement, and requires supporting very large range of delay synchronization settings because $\tau$ can be very different depending on R and C values.

US2009/0072984 discloses a power converter with a processor configured to monitor the health of a component over time.

## SUMMARY

A first aspect of the invention relates to an electronic device comprising a power source, a power management unit coupled to the power source, and a set of loads, the power management unit comprising a set of voltage regulator blocks, each voltage regulator block being respectively coupled to an associated load of the set of loads for allowing power transfer from the power source to the load. The electronic device further comprises a spike detector block, coupled to each of the voltage regulator blocks, and configured to detect a spike in a voltage signal from a voltage regulator block for testing the presence and the operability of a decoupling capacitor between an output of the voltage regulator block and an input of the associated load.

Thanks to these provisions, the performances of the electronic device may be optimized, in particular this testing principle allows to detect decoupling capacitors when power supplies are working. So, detecting decoupling capacitor on power supplies that cannot be switched off is possible, which improves testing coverage capability of the product.

The spike detector block may be integrated in the power management unit. The integration of the spike detector block into the power management unit permits to limit cost and size impact on the device.

According to a first embodiment of the invention, the output of each voltage regulator block is connected to an input of the spike detector block, said voltage signal from a voltage regulator block being an output voltage signal of the voltage regulator block.

The spike detector block may comprise an analog switch block for selecting one signal among the output voltage signals of the voltage regulator blocks as input signal of the spike detector block, a DC removal block for removing an AC component in the signal selected, an amplifier block for amplifying a signal from the DC removal block, and a peak detector block for detecting a spike in a voltage signal from the amplifier block, the corresponding decoupling capacitor being determined as not present or not functional when a spike has been detected.

The peak detector block may comprise two comparators for detecting whether the voltage signal from the amplifier block rises above a predetermined positive voltage threshold and/or falls below a corresponding negative voltage threshold, two bistable circuits for holding a spike detected by a comparator, and an OR gate for indicating if a spike has been detected.

According to a second embodiment of the invention, each voltage regulator block comprises a regulation loop configured for allowing voltage regulation, a voltage regulation error measurement signal being equal to a reference voltage signal minus an output voltage signal measured at the output of the voltage regulator block, each voltage regulator block being connected to an input of the spike detector block such that said signal from a voltage regulator block is the voltage regulation error measurement signal of the voltage regulator block.

This embodiment allows simplifying the spike detector implementation, because the spike detector doesn't need a DC removal block. This also allows improving decoupling capacitor presence detection in case several decoupling capacitors are used on the same power supply line.

The spike detector block may comprise an analog switch block for selecting one signal among the voltage regulation error measurement signals of the voltage regulator blocks as input signal of the spike detector block, an amplifier block for amplifying a signal from the analog switch block, an offset of the amplifier block being able to be set to have an average of 0V in the output of the amplifier block, and a peak detector block for detecting a spike in a signal from the amplifier block, the corresponding decoupling capacitor being determined as not present or not functional when a spike has been detected.

The peak detector block may comprise two comparators for detecting whether the voltage signal from the amplifier block rises above a predetermined positive voltage threshold or falls below a corresponding negative voltage threshold, two bi-stable circuits for holding a spike detected by a comparator, and an OR gate for indicating if a spike has been detected.

According to a variant of the second embodiment, the spike detector block may comprise an analog switch block for selecting one signal among the voltage regulation error measurement signals of the voltage regulator blocks as input signal of the spike detector block, an amplifier block for amplifying a signal coming from the analog switch block, and a peak detector block for detecting a spike in a signal coming from the amplifier block, the corresponding decoupling capacitor being determined as not present and/or not functional when a spike has been detected.

The spike detector block may be configured to set two different voltage thresholds, a spike being detected if a voltage signal rises above the first voltage threshold or falls below the second voltage threshold. It is thus unnecessary to remove the DC component of the signal because the values of the thresholds can be set separately.

According to another variant of the second embodiment, the power management unit may comprise a GPADC block coupled to the spike detector block for detecting a spike.

The spike detector block may comprise an analog switch block for selecting one signal among the voltage regulation error measurement signals of the voltage regulator blocks as input signal of the spike detector block, an absolute value amplifier block for amplifying a signal from the analog switch block, and a peak detector block comprising a diode and a serial capacitor circuitry.

A second aspect of the invention relates to a method for testing the presence and the operability of a decoupling capacitor with a power management unit comprising a set of voltage regulator blocks and a spike detector block coupled to each of the voltage regulator blocks, the method comprising:

- coupling the power management unit to a power source,
- coupling each voltage regulator block to a load for allowing power transfer from the power source to the load, and
- detecting, by means of the spike detector block, a spike in a voltage signal from a voltage regulator block for testing the presence and the operability of a decoupling capacitor between an output of the voltage regulator block and an input of the associated load.

The output of each voltage regulator block may be connected to an input of the spike detector block, said voltage signal from a voltage regulator block being an output voltage signal of the voltage regulator block.

In variant, each voltage regulator block may comprise a regulation loop allowing making voltage regulation, a voltage regulation error measurement signal being equal to a reference voltage signal minus an output voltage signal measured at the output of the voltage regulator block, each voltage regulator block being connected to an input of the spike detector block such that said signal from a voltage regulator block is the voltage regulation error measurement signal of the voltage regulator block.

**BRIEF DESCRIPTION OF THE DRAWINGS**

Embodiments of the invention are illustrated by way of example, and not by way of limitation, in the figures of the accompanying drawings, in which like reference numerals refer to similar elements and in which:

- Fig.1 is a schematic block diagram of a prior art electronic device;
- Fig.2 is a schematic block diagram of an electronic device according to a first embodiment of the invention;
- Fig.3 is a flow chart showing steps of a method for testing the presence and the operability of electronic device decoupling capacitors;
- Fig.4 is a schematic block diagram of a spike detector block of electronic device of Fig.2;
- Fig.5a to Fig.5f are charts which show an example of spike detection with the spike detector block of Fig.4;
- Fig.6 is a schematic block diagram of a voltage regulator block of an electronic device according to a second embodiment of the invention;
- Fig.7 is a schematic block diagram of the electronic device according to the second embodiment;
- Fig.8 is a schematic block diagram of a spike detector block of electronic device of Fig.7;
- Fig.9a to Fig.9e are charts which show an example of spike detection with the spike detector block of Fig.8;
- Fig.10 is a schematic block diagram of a spike detector block of electronic device of Fig.7 according to a variant of the second embodiment;
- Fig. 11a to Fig.11e are charts which show an example of spike detection with the spike detector block of Fig.10;
- Fig. 12 is a schematic block diagram showing spike detector block and part of a power management unit of electronic device of Fig.7 according to another variant of the second embodiment;
- Fig.13 is a schematic block diagram of a peak detector block according to a variant of spike detector block of Fig.12; and
- Fig.14a to Fig.14c are charts which show an example of spike detection with the spike detector block of Fig.12 comprising the peak detector block of Fig.13;

**DESCRIPTION OF PREFERRED EMBODIMENTS**

Embodiments of the invention rely on testing the presence and the operability of decoupling capacitors, in order to detect malfunctioning and/or disconnected decoupling capacitors, by detecting spikes in the power management unit by analyzing the noise on the supply lines. Indeed, presence of spikes would imply that some of the decoupling capacitors are defective or disconnected.

Fig.2 shows an electronic device 101 according to a first embodiment of the invention. Electronic device 101 may be, for example, a peripheral, a portable device, or other electronic equipment. The electronic device 101 comprises a main power supply block or power source 110, an integrated power supply circuit or power management unit 102, and four electronic circuit blocks or loads 103a to 103d. The electronic circuit blocks 103a to 103d may comprise, for example, a micro-processor, a display, a camera, and/or a connectivity sub system.

The power management unit 102 comprises four voltage regulator blocks 104a to 104d, respectively associated to the four electronic circuit blocks 103a to 103d, a spike detector block 106 and a control block 103. The numbers of voltage regulator blocks and loads are not limitative. The electronic device 101 comprises a set of decoupling capacitors, for example four decoupling capacitors $C_a$ to $C_d$, each decoupling capacitor Ca to Cd being placed between the output of a voltage regulator block 104a to 104d and the input of an electronic circuit block 103a to 103d. The integration of the spike detector block 106 into the power management unit 102 permit to limit cost and size impact on the device.

The voltage regulators 104a to 104d may be LDO (Low Drop Out) voltage regulators or SMPS (Switched Mode Power Supply) voltage regulators. The output of each voltage regulator block 104a to 104d is connected to an input of spike detector block 106, as symbolized by arrows $F_a$ to $F_d$.

The spike detector block 106 is controlled by control block 103 via dedicated control interface, as symbolized by arrow $F_{cont}$, allowing making selection of input from voltage regulator 104a to 104d to be measured. This control interface also allows making tuning of measurement, for example by setting voltage level thresholds and/or offset for spike measurement. This control interface also allows launching spike detection, and, optionally, getting back measurement result in case spike detector has no output. In the example illustrated, the spike detector 106 comprises an output allowing the control block 103 to get back measurement status, as symbolized by arrow $F_{meas}$.

A main control interface of the power management unit 102, symbolized by arrow $F_{int}$, is connected to a control unit 108 of the device 101, for example a micro controller or a micro processor or any other equipment. This main control interface $F_{int}$ allows controlling the electronic circuit blocks 103a to 103d and implicitly the spike detector 106.

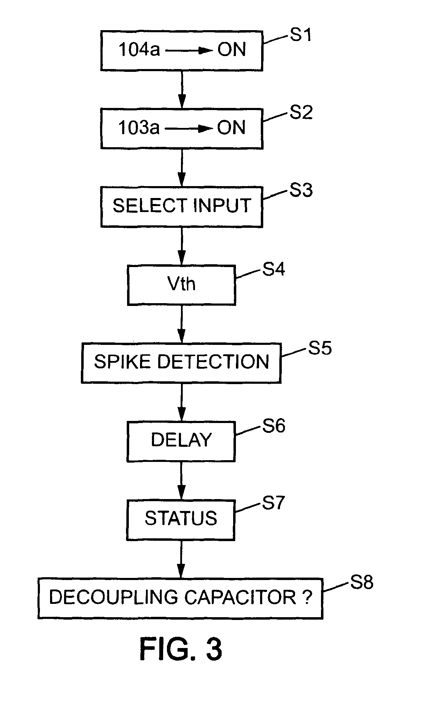

Referring to Fig.3, we are describing below a method of decoupling capacitor detection. For the detection of a decoupling capacitor $C_a$ to $C_d$, the related voltage regulator 104a to 104d needs to be switched on. Furthermore, it is preferred that related electronic circuit block 103a to 103d works in known state when performing detection.

In step S1, control unit 108 switches on the voltage regulator associated with the decoupling capacitor to be tested, for example voltage regulator 104a, via control block 103.

In step S2, control unit 108 activates the related electronic circuit block 103a.

In step S3, control unit 108 set spike detector 106 to select the output signal of voltage regulator 104a as input signal of the spike detector block.

In step S4, control unit 108 set spike detector 106 thresholds. Thresholds are voltage thresholds to be compared with voltage signal from voltage regulator 104a, as explained in details below.

In step S5, control unit 108 launches spike detection. The spike detection, described below, is realized by spike detector 106.

In step S6, control unit 108 waits a predetermined delay for measurement.

In step S7, control unit 108 read back output status of spike detector 106.

In step S8, control unit 108 tests acceptance criteria for determining if a decoupling capacitor has been detected. If the output status of the spike detector 106 indicates that no spike is detected, then decoupling capacitor $C_a$ is considered as being present and well connected. On the contrary, if the output status of the spike detector 106 indicates that one or several spikes are detected, then decoupling capacitor $C_a$ is considered as not being present and/or not being well connected and/or being defective. Indeed, if decoupling capacitor is not present, noise caused by power consumption swing/transient of circuit supplied by voltage regulator or caused by coupling from other signals or interfaces of a device is increased, so some spikes will appear.

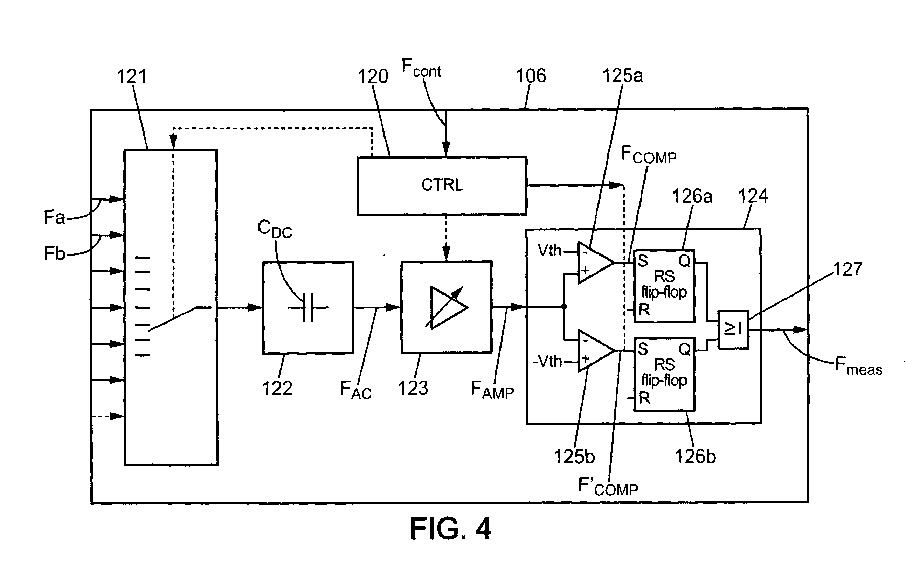

Referring to Fig.4, we are describing the spike detector block 106 and the spike detection.

Spike detector 106 comprises a control block 120, an analog switch block or analog multiplexer block 121, a DC (Direct Current) removal block 122, an amplifier block 123, and a peak detector block 124.

Control block 120 is managed, via a control input, by control block 103. Control block 110 allows setting analog switch block 121 to select voltage regulator source, setting the gain of the amplifier block 123, and resetting the peak detector block 124.

DC removal block 122 comprises a serial capacitor $C_{DC}$ which allows keeping alternative current (AC) component of signal.

Amplifier block 123 allows amplifying the AC component of signal. Amplifier gain can be set to adjust magnitude of signal that allows setting peak voltage threshold.

Peak detector block 124 comprises two comparators 125a, 125b to detect if input voltage from amplifier block 123 rises above a predetermined positive voltage threshold $+V_{th}$ or fall below a corresponding negative voltage threshold $-V_{th}$. Amplifier block 123 is set by control block 120 in order to detect only expected voltage peak.

Peak detector block 124 also comprises two bistable circuits, for example two RS flip-flop 126a, 126b, which are used to hold any voltage peak detected by comparators 125a, 125b. RS flip-flop 126a, 126b are reset by control block 120 each time before performing spike detection measurement. Peak detector block 124 also comprises an OR gate 127 having an output connected to control block 103, and which indicates if negative peak voltage or positive peak voltage have been detected.

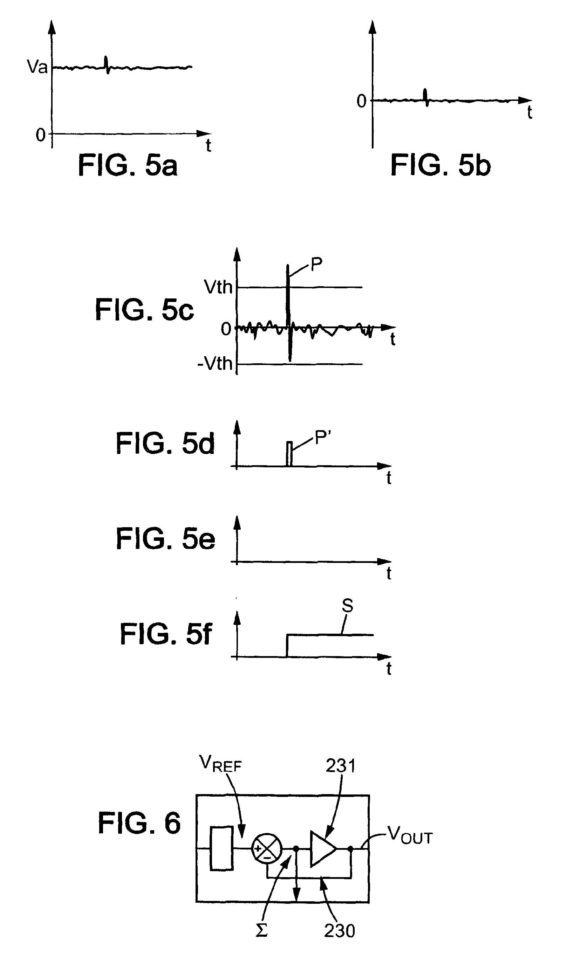

Fig.5a to Fig.5f show diagrams representing an example of spike detection.

Curve of Fig.5a represents voltage signal $V_a$ coming from a voltage regulator output, for example from the voltage regulator 104a output. This voltage signal $V_a$ is received by analog switch block 121, as symbolized by arrow $F_a$. The voltage $V_a$ comprises a DC component and an AC component.

Curve of Fig.5b represents the signal after the passage in DC removal block 122, which corresponds to the voltage transmitted from DC removal block 122 to amplifier block 123, as symbolized by arrow $F_{AC}$. This voltage only comprises the AC component of voltage $V_a$.

Curve of Fig.5c represents the signal after its passage in amplifier block 123, which corresponds to the voltage signal transmitted from amplifier block 123 to peak detector block 124, as symbolized by arrow $F_{AMP}$. The voltage signal has been amplified by amplifier block 123 and comprises in this example a peak P rising above the predetermined positive voltage threshold $+V_{th}$.

Curves of Fig.5d and Fig.5e respectively represent the signal after the passage in comparators 125a, 125b, that is the voltage signals transmitted from the comparators 125a, 125b to the respective RS flip-flop 126a, 126b, as symbolized by arrows $F_{COMP}$ and $F'_{COMP}$. Curve of Fig.5d comprises a peak P' corresponding to peak P detected by comparator 125a. As the signal represented on Fig.5c never falls below the negative voltage threshold $-V_{th}$, comparator 125b has not detected peak and as a consequence curve of Fig.5e does not comprise peak.

Curve of Fig.5f represents the signal after the passage in OR gate 127, which corresponds to the voltage transmitted from the output of spike detector block 106 to control block 103, symbolized by arrow $F_{meas}$. Curve of Fig.5f comprises a step S which indicates that at least a spike has been detected, which means that the decoupling capacitor $C_a$ is not present and/or not well connected and/or defective.

On the first embodiment describes above, the serial capacitor $C_{DC}$ of DC removal block 122 permits to remove the DC component from voltage regulator output signal. Fig. 6 to Fig.8 show a second embodiment which permit to avoid using serial capacitor.

As it can be seen on Fig. 6, a voltage regulator comprises a regulation loop 230 allowing making voltage regulation. Voltage regulation error measurement signal $\Sigma$ is equal to a reference voltage signal $V_{ref}$ minus output voltage signal $V_{out}$ measured at the output of the voltage regulator:

$$\Sigma = V_{ref} - V_{out}$$

As a consequence, voltage regulation error measurement signal $\Sigma$ is closed to an AC signal. It depends of the transfer function of a supply buffer 231 of the voltage regulator. For the description of the second embodiment, we consider worst case: transfer function of supply buffer 231 is only proportional, so there is residual DC component on voltage regulation error measurement signal $\Sigma$. This second embodiment permits to perform measurement on error signal $\Sigma$ to remove DC component.

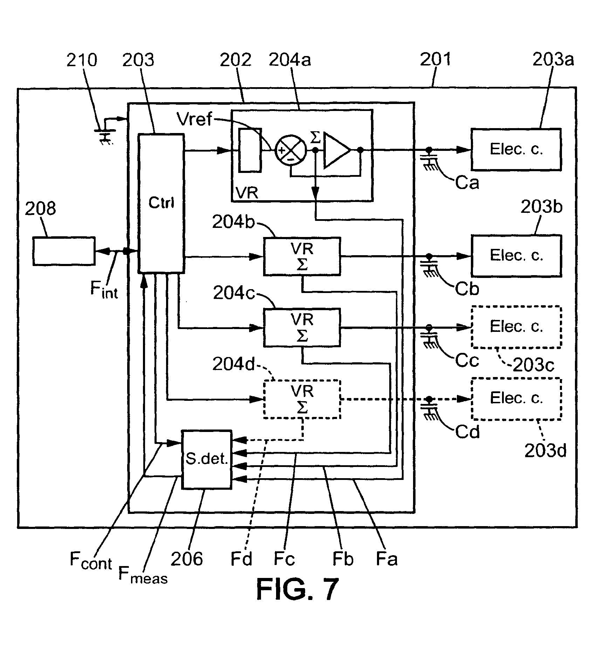

Fig.7 shows an electronic device 201 according to the second embodiment of the invention. As in the first embodiment, the electronic device 201 comprises a main power supply block 210, a power management unit 202 and four electronic circuit blocks or loads 203a to 203d. The power management unit 202 comprises four voltage regulators blocks 204a to 204d, respectively associated to the four electronic circuit blocks 203a to 203d, a spike detector block 206 and a control block 203. The electronic device 201 comprises four decoupling capacitor $C_a$ to $C_d$, respectively placed between the voltage regulators 204a to 204d and the electronic circuit blocks 203a to 203d.

The spike detector 206 is controlled by control block 203 via dedicated control interface, as symbolized by arrow $F_{cont}$. Spike detector 106 comprises an output allowing the control block 203 to get back measurement status, as symbolized by arrow $F_{meas}$. A main control interface of the power management unit 202, symbolized by arrow $F_{int}$, is connected to a control unit 208 of the device 201.

The principle is the same as for the first embodiment except that spike detection is not performed from the voltage regulator output signal but from the voltage regulation error measurement signal $\Sigma$. So, in the second embodiment, an input of the supply buffer 231 of each voltage regulator 204a to 204d, which means an output of the regulation loop 230 of each voltage regulator 204a to 204d, is connected to an input of spike detector 206, as symbolized by arrows $F'_a$ to $F'_d$. This modification allows simplifying the spike detector implementation, because the spike detector doesn't need a DC removal block. This modification also allows improving decoupling capacitor presence detection in case several decoupling capacitors are used on the same power supply line.

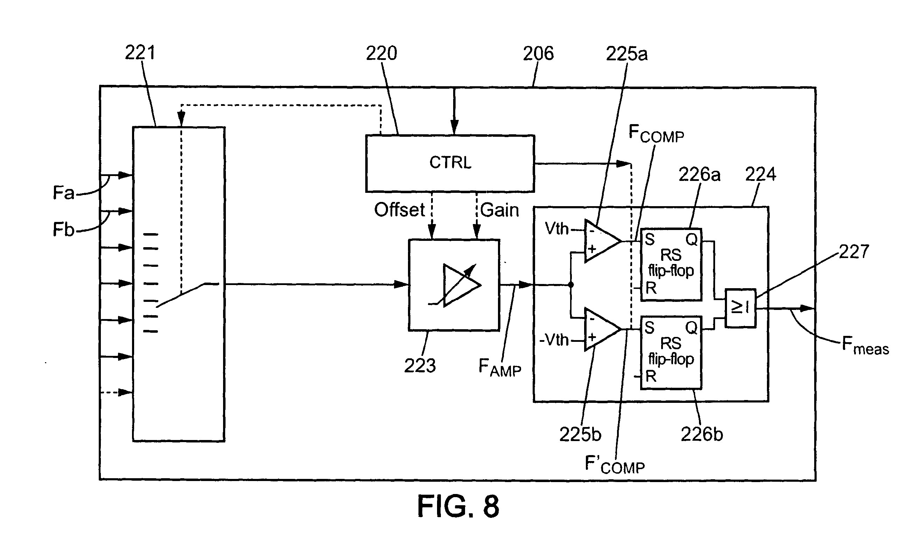

Referring to Fig.8, spike detector 206 comprises a control block 220, an analog switch block 221 similar to analog switch block 121, an amplifier block 223, and a peak detector block 224 similar to peak detector block 124.

Amplifier block 223 allows amplifying the AC component of signal and removing the DC component. Amplifier offset can be set to have an average of 0V in the output signal of the amplifier block 223. This corresponds to remove DC component.

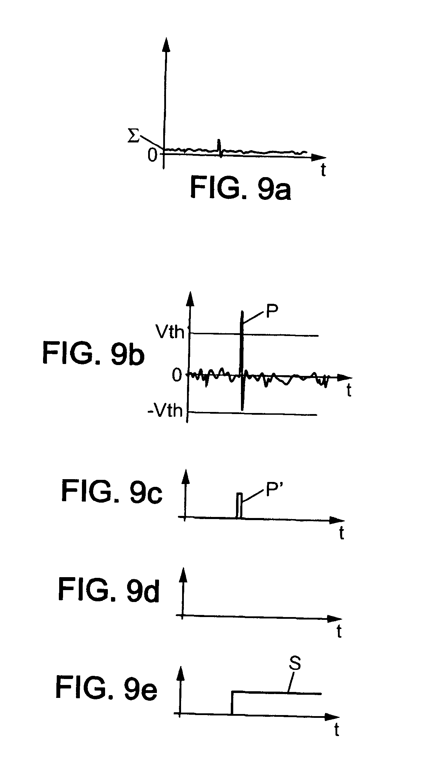

Fig.9A to Fig.9E show diagrams representing an example of spike detection with spike detector block 206.

Curve of Fig.9a represents voltage regulation error signal $\Sigma_a$ coming from the voltage regulator 204a. This signal $\Sigma_a$ is received by analog switch block 221, as symbolized by arrow $F_a$ on Fig.8. The signal $\Sigma_a$ mainly comprises an AC component.

Curve of Fig.9b represents the signal after the passage in amplifier block 223, which corresponds to the signal transmitted from amplifier block 223 to peak detector block 224, as symbolized by arrow $F_{AMP}$. In amplifier block 223, the signal has been amplified and the residual DC component has been removed. In the example, the signal comprises a peak P rising above the predetermined positive voltage threshold $+V_{th}$.

Curves of Fig.9c and Fig.9d respectively represent the signal after the passage in comparators 225a, 225b, that is the signals transmitted from the comparators 225a, 225b to the respective RS flip-flop 226a, 226b, as symbolized by arrows $F_{COMP}$ and $F'_{COMP}$. Curve of Fig. 9c comprises a peak P' corresponding to peak P detected by comparator 225a. As the signal represented on Fig. 9b never falls below the negative voltage threshold $-V_{th}$, comparator 225b has not detected peak and as a consequence curve of Fig.5d does not comprise peak.

Curve of Fig.9e represents the signal after the passage in OR gate 227, which corresponds to the signal transmitted from the output of spike detector block 206 to control block 203, symbolized by arrow $F_{meas}$. Curve of Fig.5e comprises a step S which indicates that at least a spike has been detected. As a consequence, the decoupling capacitor $C_a$ is not present and/or not well connected and/or defective.

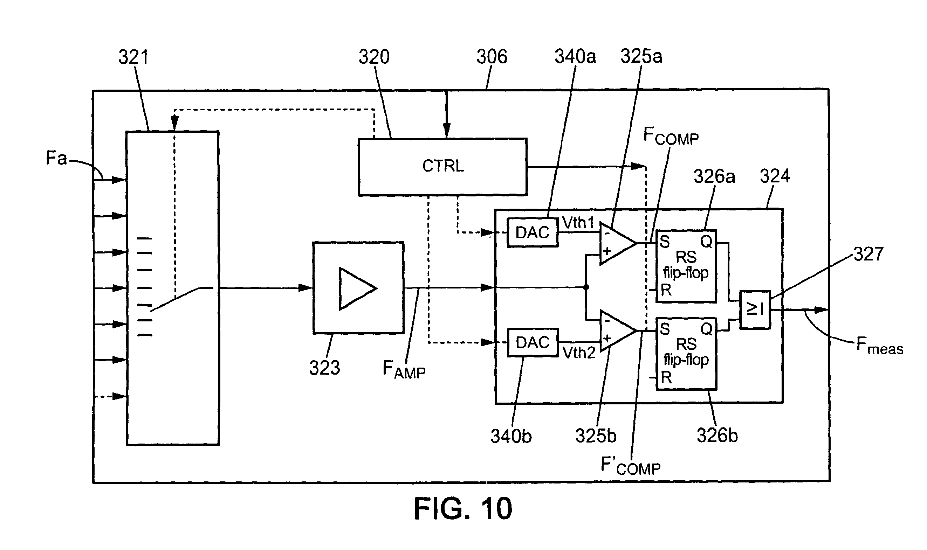

Fig.10 shows a variant of second embodiment, where spike detector 306 comprises a control block 320 further allowing setting two voltage thresholds $V_{th1}$ and $V_{th2}$ of peak detector block 224.

Amplifier block 323 has constant gain. Depending on peak detector block 324 sensitivity, the amplifier block 323 is optional.

Comparator 325a of peak detector block 324 is set with first voltage threshold $V_{th1}$ and comparator 325b of peak detector block 324 is set with second voltage threshold $V_{th2}$. First voltage threshold $V_{th1}$ is a positive voltage threshold and second voltage threshold $V_{th2}$ is a negative voltage threshold. Peak detector block 324 detects if input voltage signal from amplifier block 323 rises above threshold $V_{th1}$ or fall below threshold $V_{th2}$. It is thus unnecessary to remove the DC component of the signal because the values of the thresholds can be set separately.

Peak detector block 324 further comprises two digital to analog converters (DAC) 340a, 340b, respectively connected to the input of comparators 325a, 325b for setting thresholds $V_{th1}$ and $V_{th2}$. The DAC 340a, 340b are controlled by control block 320.

Peak detector block 324 also comprises, as before, two RS flip-flop 326a, 326b, which are used to hold any voltage peak detected by comparators 325a, 325b. RS flip-flop 326a, 326b are reset by control block 320 each time before performing spike detection measurement. Peak detector block 324 also comprises an OR gate 327. The OR gate output indicates if negative peak voltage or positive peak voltage have been detected.

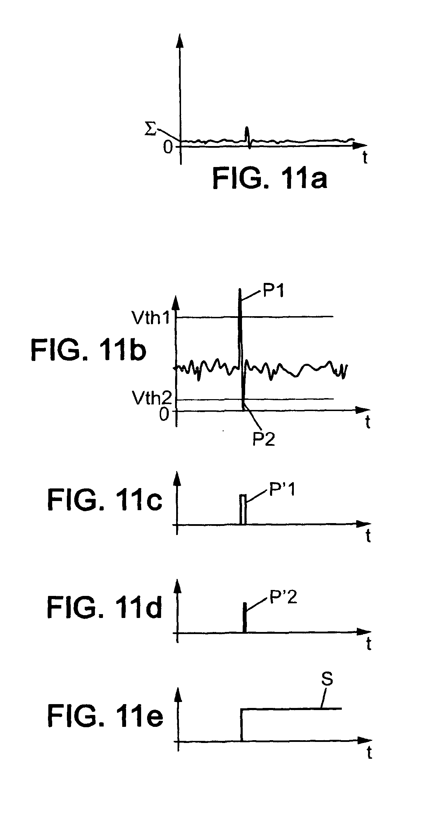

Fig.11A to Fig.11E show diagrams representing an example of spike detection with the spike detector block 306.

Curve of Fig.11a represents voltage regulation error signal $\Sigma_a$ coming from the voltage regulator block 204a. This signal $\Sigma_a$ is received by analog switch block 321, as symbolized by arrow $F'_a$ on Fig.10. The signal $\Sigma_a$ mainly comprises an AC component.

Curve of Fig.11b represents the signal after the passage in amplifier block 323, which corresponds to the signal transmitted from amplifier block 323 to peak detector block 324, as symbolized by arrow $F_{AMP}$. In amplifier block 323, the signal has been amplified but the residual DC component has not been removed. In the example, the signal comprises a peak $P_1$ rising above the first voltage threshold $V_{th1}$ and a peak $P_2$ falling below the second voltage threshold $V_{th2}$.

Curves of Fig.11c and Fig. 11d respectively represent the signal after the passage in comparators 325a, 325b, that is the signals transmitted from the comparators 325a, 325b to the respective RS flip-flop 326a, 326b, as symbolized by arrows $F_{COMP}$ and $F'_{COMP}$. Curve of Fig. 11c comprises a peak $P'_1$ corresponding to peak $P_1$ detected by comparator 325a and curve of Fig.11d comprises a peak $P'_2$ corresponding to peak $P_2$ detected by comparator 325b.

Curve of Fig.11e represents the signal after the passage in OR gate 327, which corresponds to the signal transmitted from the output of spike detector block 306 to control block 203, symbolized by arrow $F_{meas}$. Curve of Fig.11e comprises a step S which indicates that at least a spike has been detected. So the decoupling capacitor $C_a$ is not present and/or not well connected and/or defective.

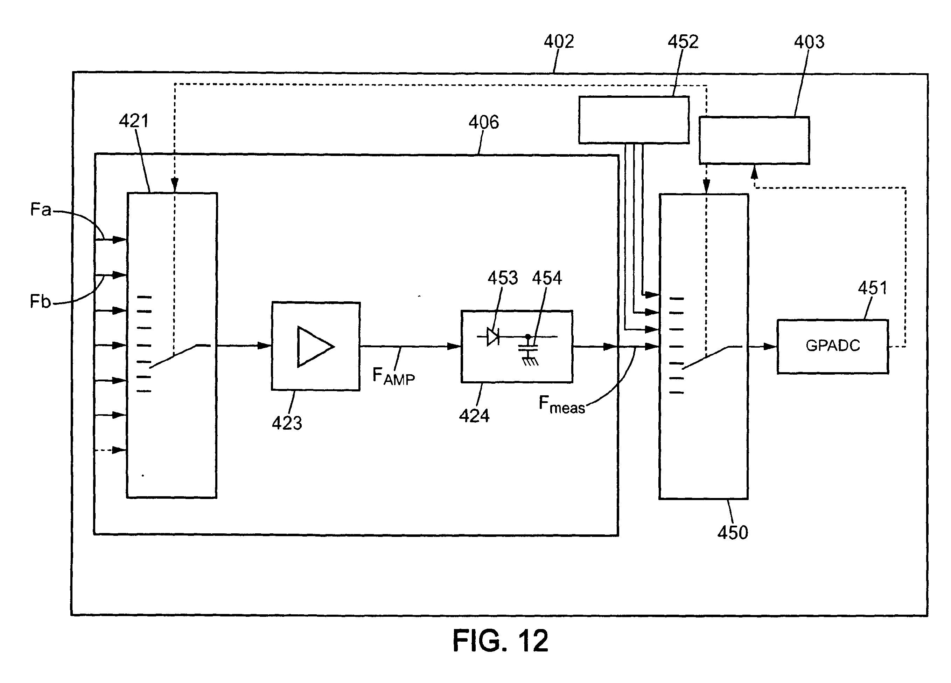

Fig.12 shows a spike detector 406 and a part of a power management unit 402 according to another variant of second embodiment. Power management unit 402 comprises, as describes before, four voltage regulator blocks not shown on Fig. 12. Power management unit 402 further comprises a spike detector block 406, an analog switch block 450, a control block 403, a General Purpose Analog to Digital Converter (GPADC) block 451, and a block 452 comprising other features of the power management unit 402. GPADC block 451 is used to detect peak voltage. Spike detector block 406 comprises an analog switch block 421, an absolute value amplifier block 423 and a peak detector block 424.

The analog switch 421 is controlled by power management unit control block 403. It allows selecting voltage regulator source depending on decoupling capacitor $C_a$ to $C_d$ to be tested.

The absolute value amplifier block 423 allows amplifying the absolute value of input signal, i.e. error signal E from voltage regulator block 204a to 204d. This amplifier 423 has constant absolute gain.

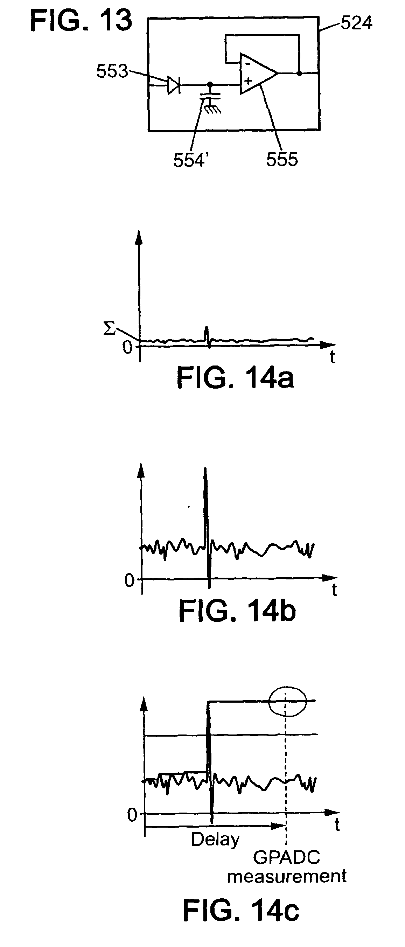

Peak detector block 424 comprises a diode 453 and a serial capacitor circuitry 454. In variant, peak detector block 424 can be replaced by peak detector block 524 of Fig.13, which comprises a diode 553, a capacitor 554' and a high impedance buffer 555. This variant avoids using an external discrete capacitor, by using a parasitic capacitor 554' followed by a high impedance buffer input.

GPADC block 451 and analog switch block 450 are used to perform measurement on the output of the spike detector block 406. They are controlled by control block 403.

To detect decoupling capacitor presence, related voltage regulator needs to be switched on. It is preferred that related electronic circuit works in know state to perform detection.

Analog switch block 450 is set to perform GPADC measurement from peak detector block 424. Then, analog switch 421 is set to select voltage regulator source 204a to 204d.

Then, after a predetermined delay, GPADC measurement is performed. If GPADC measurement value is below a predetermined digital threshold then decoupling capacitor on selected voltage regulator is considered as being present and well connected and not defective. Else, decoupling capacitor is considered has not being present and/or not being well connecting and/or being defective.

Fig.14A to Fig.14E show diagrams representing an example of spike detection with the power management unit 402.

Curve of Fig.14a represents voltage regulation error signal $\Sigma_a$ coming from the voltage regulator block 204a. This signal $\Sigma_a$ is received by analog switch block 421, as symbolized by arrow $F'_a$ on Fig.12. The signal $\Sigma_a$ mainly comprises an AC component.

Curve of Fig.14b represents the signal after the passage in amplifier block 423, which corresponds to the signal transmitted from amplifier block 423 to peak detector block 424, as symbolized by arrow $F_{AMP}$. In amplifier block 423, the signal has been amplified but the residual DC component has not been removed.

Curve of Fig.14c represents the signal after the passage in peak detector block 424, which corresponds to the signal transmitted from the output of spike detector block 406 to analog switch block 450, symbolized by arrow $F_{meas}$. Then, the signal is transmitted by the analog switch block 450 to the GPADC block 451 which compares the signal to the predetermined digital threshold. If the signal is below the digital threshold then decoupling capacitor is considered as being present and well connected and not defective. If the signal rises above the digital threshold decoupling capacitor is considered has not being present and/or not being well connecting and/or being defective.

## Claims

1. Electronic device (101, 201) comprising:

   a power source (110, 210),
   a power management unit (102, 202, 402) coupled to the power source, and
   a set of loads (103a, 103b, 103c, 103d, 203a, 203b, 203c, 203d), the power management unit comprising:

   a set of voltage regulator blocks (104a, 104b, 104c, 104d, 204a, 204b, 204c, 204d), each voltage regulator block being respectively coupled to an associated load of the set of loads for allowing power transfer from the power source to the load,
   wherein the power management unit comprises a spike detector block (106, 206, 306, 406), coupled to each of the voltage regulator blocks, and configured to detect a spike in a voltage signal from a voltage regulator block for testing the presence and the operability of a decoupling capacitor ($C_a$, $C_b$, $C_c$, $C_d$) between an output of the voltage regulator block and an input of the associated load, **characterised in that**
   each voltage regulator block (204a, 204b, 204c, 204d) comprises a regulation loop (230) configured for allowing voltage regulation, a voltage regulation error measurement signal ($\Sigma$) being equal to a reference voltage signal ($V_{ref}$) minus an output voltage signal ($V_{out}$) measured at the output of the voltage regulator block, each voltage regulator block being connected to an input of the spike detector block (206, 306, 406) such that said signal from a voltage regulator block is the voltage regulation error measurement signal of the voltage regulator block.

2. Electronic device according to claim 1, wherein the spike detector block (106, 206, 306, 406) is integrated in the power management unit.

3. Electronic device according to claim 1, wherein the output of each voltage regulator block (104a, 104b, 104c, 104d) is connected to an input of the spike detector block (106), said voltage signal from a voltage regulator block being an output voltage signal of the voltage regulator block.

4. Electronic device according to claim 3, wherein the spike detector block (106) comprises an analog switch block (121) for selecting one signal among the output voltage signals of the voltage regulator blocks as input signal of the spike detector block, a DC removal block (122) for removing an AC component in the signal selected, an amplifier block (123) for amplifying a signal from the DC removal block, and a peak detector block (124) for detecting a spike in a voltage signal from the amplifier block, the corresponding decoupling capacitor being determined as not present or not functional when a spike has been detected.

5. Electronic device according to claim 4, wherein the peak detector block (124) comprises two comparators (125a, 125b) for detecting whether the voltage signal from the amplifier block (123) rises above a predetermined positive voltage threshold ($+V_{th}$) and/or falls below a corresponding negative voltage threshold ($-V_{th}$), two bi-stable circuits (126a, 126b) for holding a spike detected by a comparator (125a, 125b), and an OR gate (127) for indicating if a spike has been detected.

6. Electronic device according to claim 1, wherein the spike detector block (206) comprises an analog switch block (221) for selecting one signal among the voltage regulation error measurement signals of the voltage regulator blocks as input signal of the spike detector block, an amplifier block (223) for amplifying a signal from the analog switch block (221), an offset of the amplifier block being able to be set to have an average of 0V in the output of the amplifier block, and a peak detector block (224) for detecting a spike in a signal from the amplifier block, the corresponding decoupling capacitor being determined as not present or not functional when a spike has been detected.

7. Electronic device according to claim 6, wherein the peak detector block (224) comprises two comparators (225a, 225b) for detecting whether the voltage signal from the amplifier block (223) rises above a predetermined positive voltage threshold ($+V_{th}$) or falls below a corresponding negative voltage threshold ($-V_{th}$), two bi-stable circuits (126a, 126b) for holding a spike detected by a comparator (225a, 225b), and an OR gate (127) for indicating if a spike has been detected.

8. Electronic device according to claim 1, wherein the spike detector block (306) comprises an analog switch block (321) for selecting one signal among the voltage regulation error measurement signals of the voltage regulator blocks as input signal of the spike detector block, an amplifier block (323) for amplifying a signal coming from the analog switch block (321), and a peak detector block (324) for detecting a spike in a signal coming from the amplifier block, the corresponding decoupling capacitor being determined as not present and/or not functional when a spike has been detected.

9. Electronic device according to claim 8, wherein the spike detector block (306) is configured to set two different voltage thresholds ($V_{th1}$, $V_{th2}$), a spike being detected if a voltage signal rises above the first voltage threshold ($V_{th1}$) or falls below the second voltage threshold ($V_{th2}$).

10. Electronic device according to claim 1, wherein the power management unit (402) comprises a General Purpose Analog to Digital Converter, GPADC, block (451) coupled to the spike detector block (406) for detecting a spike.

11. Electronic device according to claim 10, wherein the spike detector block (406) comprises an analog switch block (421) for selecting one signal among the voltage regulation error measurement signals of the voltage regulator blocks as input signal of the spike detector block, an absolute value amplifier block (423) for amplifying a signal from the analog switch block (321), and a peak detector block (424) comprising a diode (453) and a serial capacitor circuitry (454).

12. Method for testing the presence and the operability of a decoupling capacitor with a power management unit (102, 202, 402) comprising a set of voltage regulator blocks (104a, 104b, 104c, 104d, 204a, 204b, 204c, 204d) and a spike detector block (106, 206, 306, 406) coupled to each of the voltage regulator blocks, the power management unit being coupled to a power source (103a, 103b, 103c, 103d, 203a, 203b, 203c, 203d), and each voltage regulator block being coupled to a load for allowing power transfer from the power source to the load, the method comprising :

    detecting, by means of the spike detector block, a spike in a voltage signal from a voltage regulator block for testing the presence and the operability of a decoupling capacitor between an output of the voltage regulator block and an input of the associated load **characterized in that** each voltage regulator block comprises a regulation loop (230) allowing making voltage regulation, a voltage regulation error measurement signal ($\Sigma$) being equal to a reference voltage signal ($V_{ref}$) minus an output voltage signal ($V_{out}$) measured at the output of the voltage regulator block, each voltage regulator block (204a, 204b, 204c, 204d) being connected to an input of the spike detector block (206, 306, 406) such that said signal from a voltage regulator block is the voltage regulation error measurement signal of the voltage regulator block.

13. Method according to claim 12, wherein the output of each voltage regulator block (104a, 104b, 104c, 104d) is connected to an input of the spike detector block (106), said voltage signal from a voltage regulator block being an output voltage signal of the voltage regulator block.

**Patentansprüche**

1. Elektronisches Gerät (101, 201) mit:

    einer Stromquelle (110, 210);
    einer Energiespareinheit (102, 202, 402), die an die Stromquelle angeschlossen ist, und
    einem Satz von Verbrauchern (103a, 103b, 103c, 103d, 203a, 203b, 203c, 203d), wobei die Energiespareinheit aufweist:

    einen Satz von Spannungsreglerblöcken (104a, 104b, 104c, 104d, 204a, 204b, 204c, 204d), wobei jeder Spannungsreglerblock jeweils an einen zugehörigen Verbraucher aus dem Satz von Verbrauchern angeschlossen ist, um eine Energieübertragung von der Stromquelle auf den Verbraucher zu ermöglichen,
    wobei die Energiespareinheit einen Überschwingspitzen-Detektorblock (106, 206, 306, 406) aufweist, der an jeden der Spannungsreglerblöcke angeschlossen und eingerichtet ist, eine Überschwingspitze in einem Spannungssignal aus einem Spannungsreglerblock zu detektieren, um die Präsenz und die Betriebsfähigkeit eines Entstörkondensators ($C_a$, $C_b$, $C_c$, $C_d$) zwischen einem Ausgang des Spannungsreglerblocks und einem Eingang des zugehörigen Verbrauchers zu prüfen, **dadurch gekennzeichnet, dass**

jeder Spannungsreglerblock (204a, 204b, 204c, 204d) eine Regelschleife (230) aufweist, die eingerichtet ist, eine Spannungsregelung zu ermöglichen, wobei ein Spannungsregelungsfehler-Messsignal ($\Sigma$) gleich einem Bezugsspannungssignal ($V_{ref}$) minus einem Ausgangsspannungssignal ($V_{out}$) ist, das am Ausgang des Spannungsreglerblocks gemessen wird, wobei jeder Spannungsreglerblock derart mit einem Eingang des Überschwingspitzen-Detektorblocks (206, 306, 406) verbunden ist, dass das Signal aus einem Spannungsreglerblock das Spannungsregelungsfehler-Messsignal des Spannungsreglerblocks ist.

2. Elektronisches Gerät nach Anspruch 1, wobei der Überschwingspitzen-Detektorblock (106, 206, 306, 406) in die Energiespareinheit integriert ist.

3. Elektronisches Gerät nach Anspruch 1, wobei der Ausgang eines jeden Spannungsreglerblocks (104a, 104b, 104c, 104d) an einen Eingang des Überschwingspitzen-Detektorblocks (106) angeschlossen ist, wobei das Spannungssignal aus einem Spannungsreglerblock ein Ausgangsspannungssignal des Spannungsreglerblocks ist.

4. Elektronisches Gerät nach Anspruch 3, wobei der Überschwingspitzen-Detektorblock (106) aufweist:

einen Analogschalterblock (121), um ein Signal unter den Ausgangsspannungssignalen der Spannungsreglerblöcke als Eingangssignal des Überschwingspitzen-Detektorblocks auszuwählen, einen Gleichstrombeseitigungsblock (122) zum Beseitigen einer Wechselstromkomponente in dem ausgewählten Signal, einen Verstärkerblock (123) zum Verstärken eines Signals aus dem Gleichstrombeseitigungsblock und einen Spitzendetektorblock (124) zum Detektieren einer Überschwingspitze in einem Spannungssignal aus dem Verstärkerblock, wobei festgelegt wird, dass der entsprechende Entstörkondensator nach dem Detektieren einer Überschwingspitze nicht präsent oder nicht funktionsfähig ist.

5. Elektronisches Gerät nach Anspruch 4, wobei der Spitzendetektorblock (124) aufweist: zwei Komparatoren (125a, 125b), um zu detektieren, ob das Spannungssignal aus dem Verstärkerblock (123) über einen vorgegebenen positiven Schwellenwert ($+V_{th}$) ansteigt und/oder unter einen entsprechenden negativen positiven Schwellenwert ($-V_{th}$) abfällt, zwei bistabile Schaltkreise (126a, 126b) zum Halten einer Überschwingspitze, die durch einen Komparator (125a, 125b) detektiert wurde, und ein OR-Gatter (127) zum Anzeigen, wenn eine Überschwingspitze detektiert wurde.

6. Elektronisches Gerät nach Anspruch 1, wobei der Überschwingspitzen-Detektorblock (206) aufweist:

einen Analogschalterblock (221) zum Auswählen eines Signals unter den Spannungsregelungsfehler-Messsignalen der Spannungsreglerblöcke als ein Eingangssignal des Überschwingspitzen-Detektorblocks, einen Verstärkerblock (223) zum Verstärken eines Signals aus dem Analogschalterblock (221), wobei ein Offset des Verstärkerblocks so festgelegt werden kann, dass ein Mittelwert von 0V im Ausgang des Verstärkerblocks erhalten wird, und einen Spitzendetektorblock (224) zum Detektieren einer Überschwingspitze in einem Signal aus dem Verstärkerblock, wobei festgelegt wird, dass der entsprechende Entstörkondensator nach dem Detektieren einer Überschwingspitze nicht präsent oder nicht funktionsfähig ist.

7. Elektronisches Gerät nach Anspruch 6, wobei der Spitzendetektorblock (224) aufweist: zwei Komparatoren (225a, 225b), um zu detektieren, ob das Spannungssignal aus dem Verstärkerblock (223) über einen vorgegebenen positiven Schwellenwert ($+V_{th}$) ansteigt und/oder unter einen entsprechenden negativen positiven Schwellenwert ($-V_{th}$) abfällt, zwei bistabile Schaltkreise (126a, 126b) zum Halten einer Überschwingspitze, die durch einen Komparator (225a, 225b) detektiert wurde, und ein OR-Gatter (127) zum Anzeigen, wenn eine Überschwingspitze detektiert wurde.

8. Elektronisches Gerät nach Anspruch 1, wobei der Überschwingspitzen-Detektorblock (306) aufweist:

einen Analogschalterblock (321) zum Auswählen eines Signals unter den Spannungsregelungsfehler-Messsignalen der Spannungsreglerblöcke als ein Eingangssignal des Überschwingspitzen-Detektorblocks, einen Verstärkerblock (323) zum Verstärken eines Signals, das aus dem Analogschalterblock (321) kommt, und einen Spitzendetektorblock (324) zum Detektieren einer Überschwingspitze in einem Signal, das aus dem Verstärkerblock kommt, wobei festgelegt wird, dass der entsprechende Entstörkondensator nach dem Detektieren einer Überschwingspitze nicht präsent oder nicht funktionsfähig ist.

9. Elektronisches Gerät nach Anspruch 8, wobei der Überschwingspitzen-Detektorblock (306) eingerichtet ist, zwei unterschiedliche Spannungsschwellenwerte ($V_{th1}$, $V_{th2}$) festzulegen, wobei eine Über-

schwingspitze detektiert wird, wenn ein Spannungssignal über den ersten Spannungsschwellenwert ($V_{th1}$) ansteigt oder unter den zweiten Spannungsschwellenwerte ($V_{th2}$) abfällt.

10. Elektronisches Gerät nach Anspruch 1, wobei die Energiespareinheit (402) einen Allzweck-Analog-Digital-Wandler(GPADC)-Block (451) aufweist, der mit dem Überschwingspitzen-Detektorblock (406) zum Detektieren einer Überschwingspitze gekoppelt ist.

11. Elektronisches Gerät nach Anspruch 10, wobei der Überschwingspitzen-Detektorblock (406) aufweist:

einen Analogschalterblock (421) zum Auswählen eines Signals unter den Spannungsregelungsfehler-Messsignalen der Spannungsreglerblöcke als Eingangssignal des Überschwingspitzen-Detektorblocks, einen Absolutwert-Verstärkerblock (423) zum Verstärken eines Signals aus dem Analogschalterblock (321) und einen Spitzendetektorblock (424), der eine Diode (453) und eine Kondensatorreihenschaltung (454) aufweist.

12. Verfahren zum Testen der Präsenz und der Betriebsfähigkeit eines Entstörkondensators mit einer Energiespareinheit (102, 202, 402), die einen Satz von Spannungsreglerblöcken (104a, 104b, 104c, 104d, 204a, 204b, 204c, 204d) und einen Überschwingspitzen-Detektorblock (106, 206, 306, 406) aufweist, der an jeden der Spannungsreglerblöcke angeschlossen ist, wobei die Energiespareinheit an eine Spannungsquelle (103a, 103b, 103c, 103d, 203a, 203b, 203c, 203d) gekoppelt ist und jeder Spannungsreglerblock an einen Verbraucher gekoppelt ist, um eine Energieübertragung von der Spannungsquelle zum Verbraucher zu ermöglichen, wobei das Verfahren umfasst:

Detektieren einer Überschwingspitze in einem Spannungssignal aus einem Spannungsreglerblock mithilfe des Überschwingspitzen-Detektorblocks, um die Präsenz und die Betriebsfähigkeit eines Entstörkondensators zwischen einem Ausgang des Spannungsreglerblocks und einem Eingang des zugehörigen Verbrauchers zu prüfen, **dadurch gekennzeichnet, dass** jeder Spannungsreglerblock eine Regelschleife (230) aufweist, die das Ausführen der Spannungsregelung erlaubt, wobei ein Spannungsregelungsfehler-Messsignal ($\Sigma$) gleich einem Bezugsspannungssignal ($V_{ref}$) minus einem Ausgangsspannungssignal ($V_{out}$) ist, das am Ausgang des Spannungsreglerblocks gemessen wird, wobei jeder Spannungsreglerblock (204a, 204b, 204c, 204d) derart mit einem Eingang des Überschwingspitzen-Detektorblocks (206, 306, 406) verbunden ist, dass das Signal aus einem Spannungsreglerblock das Spannungsregelungsfehler-Messsignal des Spannungsreglerblocks ist.

13. Verfahren nach Anspruch 12, wobei der Ausgang eines jeden Spannungsreglerblocks (104a, 104b, 104c, 104d) mit einem Eingang des Überschwingspitzen-Detektorblocks (106) verbunden ist, wobei das Spannungssignal aus einem Spannungsreglerblock ein Ausgangsspannungssignal des Spannungsreglerblocks ist.

**Revendications**

1. Dispositif électronique (101, 201) comprenant :

une source de puissance (110, 210),
une unité de gestion de puissance (102, 202, 402) couplée à la source de puissance, et
un ensemble de charges (103a, 103b, 103c, 103d, 203a, 203b, 203c, 203d), l'unité de gestion de puissance comprenant :

un ensemble de blocs régulateurs de tension (104a, 104b, 104c, 104d, 204a, 204b, 204c, 204d), chaque bloc régulateur de tension étant respectivement couplé à une charge associée de l'ensemble de charges pour permettre le transfert de puissance de la source de puissance à la charge, dans lequel l'unité de gestion de puissance comprend un bloc détecteur de pointe (106, 206, 306, 406), couplé à chacun des blocs régulateurs de tension, et configuré pour détecter une pointe dans un signal de tension provenant d'un bloc régulateur de tension pour tester la présence et l'opérabilité d'un condensateur de découplage ($C_a$, $C_b$, $C_c$, $C_d$) entre une sortie du bloc régulateur de tension et une entrée de la charge associée, **caractérisé en ce que** chaque bloc régulateur de tension (204a, 204b, 204c, 204d) comprend une boucle de régulation (230) configurée pour permettre une régulation de tension, un signal de mesure d'erreur de régulation de tension ($\Sigma$) étant égal à un signal de tension de référence ($V_{ref}$) moins un signal de tension de sortie ($V_{out}$) mesuré à la sortie du bloc régulateur de tension, chaque bloc régulateur de tension étant relié à une entrée du bloc détecteur de pointe (206, 306, 406) de sorte que ledit signal provenant d'un bloc régulateur de tension est le signal de mesure d'erreur de régulation de tension du bloc régulateur de tension.

**2.** Dispositif électronique selon la revendication 1, dans lequel le bloc détecteur de pointe (106, 206, 306, 406) est intégré à l'unité de gestion de puissance.

**3.** Dispositif électronique selon la revendication 1, dans lequel la sortie de chaque bloc régulateur de tension (104a, 104b, 104c, 104d) est reliée à une entrée du bloc détecteur de pointe (106), ledit signal de tension provenant d'un bloc régulateur de tension étant un signal de tension de sortie du bloc régulateur de tension.

**4.** Dispositif électronique selon la revendication 3, dans lequel le bloc détecteur de pointe (106) comprend un bloc commutateur analogique (121) pour sélectionner un signal parmi les signaux de tension de sortie des blocs régulateurs de tension en tant que signal d'entrée du bloc détecteur de pointe, un bloc de suppression de courant continu, CC, (122) pour supprimer une composante de courant alternatif, CA, dans le signal sélectionné, un bloc amplificateur (123) pour amplifier un signal provenant du bloc de suppression CC, et un bloc détecteur de pointe (124) pour détecter une pointe dans un signal de tension provenant du bloc amplificateur, le condensateur de découplage correspondant étant déterminé comme n'étant pas présent ou pas fonctionnel lorsqu'une pointe est détectée.

**5.** Dispositif électronique selon la revendication 4, dans lequel le bloc détecteur de pointe (124) comprend deux comparateurs (125a, 125b) pour détecter si le signal de tension provenant du bloc amplificateur (123) monte au-dessus d'un seuil de tension positive prédéterminé $(+V_{th})$ et/ou descend au-dessous d'un seuil de tension négative correspondant $(-V_{th})$, deux circuits bistables (126a, 126b) pour maintenir une pointe détectée par un comparateur (125a, 125b) et une grille OR (127) pour indiquer si une pointe est détectée.

**6.** Dispositif électronique selon la revendication 1, dans lequel le bloc détecteur de pointe (206) comprend un bloc commutateur analogique (221) pour sélectionner un signal parmi les signaux de mesure d'erreur de régulation de tension des blocs régulateurs de tension en tant que signal d'entrée du bloc détecteur de pointe, un bloc amplificateur (223) pour amplifier un signal provenant du bloc commutateur analogique (221), un décalage du bloc amplificateur pouvant être réglé pour avoir une moyenne de 0 V dans la sortie du bloc amplificateur, et un bloc détecteur de pointe (224) pour détecter une pointe dans un signal provenant du bloc amplificateur, le condensateur de découplage correspondant étant déterminé comme n'étant pas présent ou pas fonctionnel lorsqu'une pointe est détectée.

**7.** Dispositif électronique selon la revendication 6, dans lequel le bloc détecteur de pointe (224) comprend deux comparateurs (225a, 225b) pour détecter si le signal de tension provenant du bloc amplificateur (223) monte au-dessus d'un seuil de tension positive prédéterminé $(+V_{th})$ ou descend au-dessous d'un seuil de tension négative correspondant $(-V_{th})$, deux circuits bistables (126a, 126b) pour maintenir une pointe détectée par un comparateur (225a, 225b) et une grille OR (127) pour indiquer si une pointe est détectée.

**8.** Dispositif électronique selon la revendication 1, dans lequel le bloc détecteur de pointe (306) comprend un bloc commutateur analogique (321) pour sélectionner un signal parmi les signaux de mesure d'erreur de régulation de tension des blocs régulateurs de tension en tant que signal d'entrée du bloc détecteur de pointe, un bloc amplificateur (323) pour amplifier un signal provenant du bloc commutateur analogique (321), et un bloc détecteur de pointe (324) pour détecter une pointe dans un signal de tension provenant du bloc amplificateur, le condensateur de découplage correspondant étant déterminé comme n'étant pas présent et/ou pas fonctionnel lorsqu'une pointe est détectée.

**9.** Dispositif électronique selon la revendication 8, dans lequel le bloc détecteur de pointe (306) est configuré pour régler deux seuils de tension différents $(V_{th1}, V_{th2})$, une pointe étant détectée si un signal de tension monte au-dessus du premier seuil de tension $(V_{th1})$ ou descend au-dessous du deuxième seuil de tension correspondant $(V_{th2})$.

**10.** Dispositif électronique selon la revendication 1, dans lequel l'unité de gestion de puissance (402) comprend un bloc convertisseur analogique-numérique d'usage général, GPADC, (451) couplé au bloc détecteur de pointe (406) pour détecter une pointe.

**11.** Dispositif électronique selon la revendication 10, dans lequel le bloc détecteur de pointe (-406) comprend un bloc commutateur analogique (421) pour sélectionner un signal parmi les signaux de mesure d'erreur de régulation de tension des blocs régulateurs de tension en tant que signal d'entrée du bloc détecteur de pointe, un bloc amplificateur de valeur absolue (423) pour amplifier un signal provenant du bloc commutateur analogique (321), et un bloc détecteur de pointe (424) comprenant une diode (453) et une circuiterie de condensateur en série (454).

**12.** Procédé pour tester la présence et l'opérabilité d'un condensateur de découplage avec une unité de gestion de puissance (102, 202, 402) comprenant un ensemble de blocs régulateurs de tension (104a, 104b, 104c, 104d, 204a, 204b, 204c, 204d) et un bloc détecteur de pointe (106, 206, 306, 406) couplé à chacun des blocs régulateurs de tension, l'unité de gestion de puissance étant couplée à une source de puissance (103a, 103b, 103c, 103d, 203a, 203b, 203c, 203d), et chaque bloc régulateur de tension étant couplé à une charge pour permettre le transfert de puissance de la source de puissance à la charge, le procédé comprenant :

la détection, au moyen du bloc détecteur de pointe, d'une pointe dans un signal de tension provenant d'un bloc régulateur de tension pour tester la présence et l'opérabilité d'un condensateur de découplage entre une sortie du bloc régulateur de tension et une entrée de la charge associée, **caractérisé en ce que**
chaque bloc régulateur de tension comprend une boucle de régulation (230) permettant d'effectuer une régulation de tension, un signal de mesure d'erreur de régulation de tension ($\Sigma$) étant égal à un signal de tension de référence ($V_{ref}$) moins un signal de tension de sortie ($V_{out}$) mesuré à la sortie du bloc régulateur de tension, chaque bloc régulateur de tension (204a, 204b, 204c, 204d) étant relié à une entrée du bloc détecteur de pointe (206, 306, 406) de sorte que ledit signal provenant d'un bloc régulateur de tension est le signal de mesure d'erreur de régulation de tension du bloc régulateur de tension.

13. Procédé selon la revendication 12, dans lequel la sortie de chaque bloc régulateur de tension (104a, 104b, 104c, 104d) est reliée à une entrée du bloc détecteur de pointe (106), ledit signal de tension provenant d'un bloc régulateur de tension étant un signal de tension de sortie du bloc régulateur de tension.

**FIG. 1**

**FIG. 2**

FIG. 3

**FIG. 4**

FIG. 5a

FIG. 5b

FIG. 5c

FIG. 5d

FIG. 5e

FIG. 5f

FIG. 6

**FIG. 7**

FIG. 8

FIG. 9a

FIG. 9b

FIG. 9c

FIG. 9d

FIG. 9e

FIG. 10

FIG. 11a

FIG. 11b

FIG. 11c

FIG. 11d

FIG. 11e

**FIG. 12**

EP 2 434 363 B1

FIG. 13

FIG. 14a

FIG. 14b

Delay

GPADC
measurement

FIG. 14c

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090072984 A